Europäisches Patentamt

European Patent Office

Office européen des brevets

(11) Publication number: **0 022 108**
**A1**

(12) **EUROPEAN PATENT APPLICATION**

(21) Application number: **80850095.3**

(22) Date of filing: **17.06.80**

(51) Int. Cl.³: **H 03 G 5/18**
**G 11 B 5/45**

(30) Priority: **19.06.79 NO 792037**

(43) Date of publication of application:
**07.01.81 Bulletin 81/1**

(84) Designated Contracting States:
**AT BE DE FR GB IT LU NL SE**

(71) Applicant: **Lia, Hermann**
**58 a Likollen**
**N-1481 Li(NO)**

(72) Inventor: **Lia, Hermann**
**58 a Likollen**
**N-1481 Li(NO)**

(74) Representative: **Linden, Jan Gunnar**
**AB STOCKHOLMS PATENTBYRA Zacco & Bruhn Box 3129**
**S-103 62 Stockholm(SE)**

(54) **Method and means for improving the high frequency response in magnetic audio recording.**

(57) introduction of dynamic equalization in the recording amplifiers feedback loop which contains an LC-resonance circuit L,$C_1$ which is damped in accordance with the output level of the amplifier G(s), so that by increasing levels beyond a fixed value the influence of the resonance circuit is gradually reduced and finally eliminated.

Fig. 3

EP 0 022 108 A1

METHOD AND MEANS FOR IMPROVING THE HIGH FREQUENCY
RESPONSE IN MAGNETIC AUDIO RECORDING

The present invention relates to a method and
means for improving the high frequency response in
magnetic audio recording, especially cassette decks
by which the tape speed is relatively low.

In order to achieve flat frequency response
throughout the 20 to 20 000 Hz audio spectrum, the audio
signal supplied to the recording head must be given a
rather large treble boost and a slight bass boost. The
process of pre-emphazing the high and low frequencies before they reach the tape is called recording
equalization, and is intended to equalize the overall
recording-playback frequency response of the apparatus,
by use of normal playback head and internationally
standardised playback equalization. As the absolute
amount of recording equalization used may vary slightly
from one model to another, the curve A shown in figure
1 is typical for a top quality cassette deck in which
flat response is maintained up to 20 000 Hz.

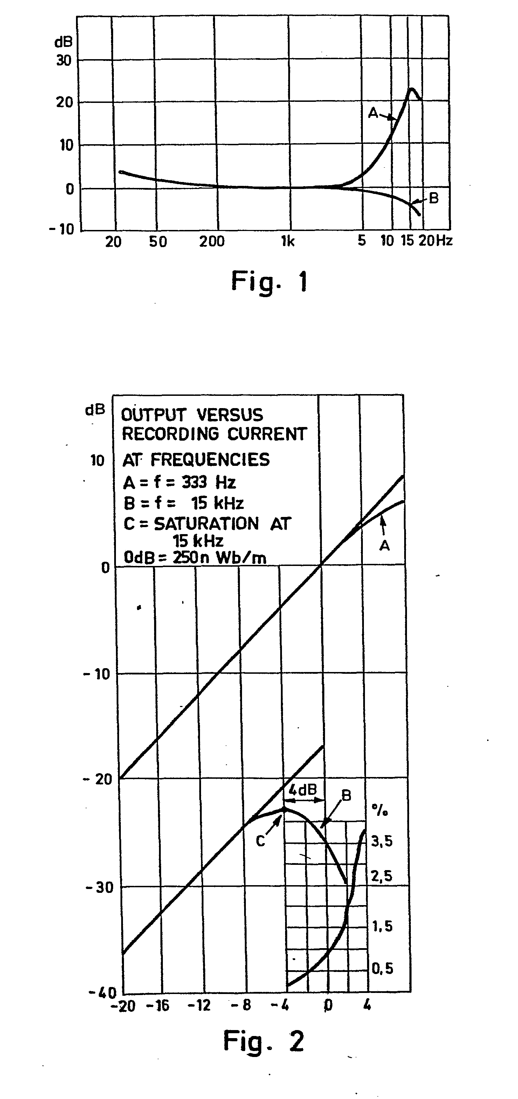

Using the recording treble pre-emphasis A in
figure 1 (the amount of bass boost is so small that it
can be ignored in the present case), it is possible to
obtain flat frequency response with a top quality
apparatus, provided the input level to the recording
head is sufficiently small in the high-frequency area.
Usually the test of frequency response of, for instance
cassette decks, is made at a level 20 to 30 dB below
the DIN reference level of 250 nWb/m. Unfortunately,
however in practice the high frequency content of music
signals often exceeds the safe level, and high-
frequency "overload" appears which is magnetic
saturation of the tape, which is a serious problem by
users of cassette decks since the introduction of the
slowspeed format.

This problem will be explained further with reference to figure 2 which shows the signal-handling
capacity of the tape itself at high and low frequencies
and which were made using a high-quality cassette tape
(Maxell UDXL I) and a cassette deck (Tandberg TCD 440A).

These input/output curves disclose a number of
interesting points beyond the obvious fact that the
tape will not hold nearly as much signal at 15000 Hz as
it will at 333 Hz.  For one thing the linear portion
of the curves A and B, where the output faithfully
tracks the input level, the distance between the two
parallel diagonal lines simultaneously represents: a)
the amount of record equalization needed to obtain flat
frequency response and b) the number of dB below a
so-called "0-VU" level that must be used by recording
in order to achieve a flat frequency response.  For
another thing, it can be seen that -24 dB represents
the maximum obtainable output point "C" on the curve at
15 kHz, and from the point of view of the tape, it does
not matter whether the corresponding input level,
supplied by the music alone, with no recording
equalization, or by a lower-level musical harmonic
boosted up by conventional record equalization, the tape
will hold just so much 15 kHz information and not a
fraction of a dB more.

The recording signal may be increased to 4 dB at 333 Hz and the distortion is then 4%. At 15 kHz
the linearity is maintained to -8 dB, with a maximum
output at -4 dB indicated by the point C in figure 2.
An increase of the recording signal above the said
point results in a decreased output while the intermodulation increases very fast as shown.

The object of the present invention is therefore to achieve an expansion of the higher frequency
input signals without introducing intermodulation
which exceeds the standard 5%.

This is according to the invention obtained
by introduction of dynamic equalization in the
recording amplifier, in that lower levels are given
the usual recording equalization and as the input
level increases the equalization is gradually decreased
to a flat frequency response in the recording amplifier.

Below one embodiment of the invention will be
explained in reference to the drawing.

In the drawing figure 1 the curve A shows a
usual recording equalization, and the curve B shows a
recording equalization which is necessary to obtain
5% intermodulation at any frequency.

Figure 2 shows the signal-handling capacity of
the tape itself at high and low frequencies.

Figure 3 shows a diagram for a recording amplifier according to the present invention.

Figure 4 shows the resulting overall frequency response of a cassette deck using the means according to the invention compared with the frequency response of a conventional cassette deck at 250 nWb/m recording level.

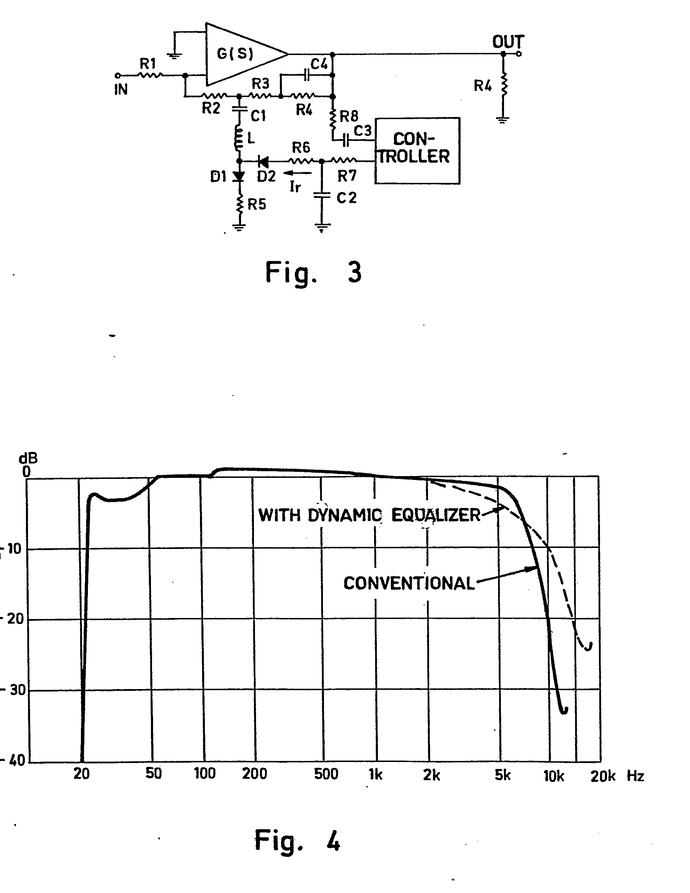

The recording amplifier in figure 3 has a frequency response adaptive to the input level, determined by the feedback loop, which contains a resonance circuit LC1 giving a peak in the frequency response at 20 kHz. The peak is damped by the components D1, D2, R5 and R6. The diode resistance is a function of the current through them, and the damping of the peak is controlled by the current Ir. The controller monitors the output level of the amplifier G(s) and produces the control current Ir, which remains constant 2 mA at low levels which results in a low diode resistance and therefore a peak at high frequencies, mainly determined by R5 and R6 in parallel.

As the input level increases beyond a fixed value, the controller takes action and reduces the current Ir and thereby increases the diode resistance and consequently the preemphazing is reduced. At extremely high input levels the control current Ir

equals zero and the influence of the resonance circuit is removed completely. The amplification is determined by (R2 + R3)/R3 for the medium frequencies and R4.C4 determines the boost of the lower frequencies.

Figure 4 shows the improved frequency response obtained by preventing saturation of the tape at higher frequencies according to the invention, which by reference level 0 dB gives 12 dB greater output at 10 kHz.

Having described my invention, I claim:

1.      Method for improving the high frequency response in magnetic audio recording, by introduction of dynamic equalization in the recording amplifier, in that the lower levels are given the usual recording equalization, and as the input level increases the equalization is gradually decreased to a flat frequency response in the recording amplifier.

2.      Means for improving the high frequency response in magnetic audio recording, wherein the recording amplifier has a feedback loop which contains an LC-resonance circuit giving a peak in the frequency response at for instance 20 kHz, which peak is damped by diodes and resistances, so that the diode resistance is a function of the current through the diode, which current is delivered by a controller which monitors the output level of the amplifier, and at low levels remains constant giving low diode resistance, and as the signal level increases beyond a fixed level, the controller reduces the current and thereby the diode resistance increases, so that the influence of the resonance circuit is gradually removed.

0022108

1/2

Fig. 1

Fig. 2

OUTPUT VERSUS
RECORDING CURRENT
AT FREQUENCIES
A = f = 333 Hz
B = f = 15 kHz
C = SATURATION AT
   15 kHz
0dB = 250n Wb/m

Fig. 3

WITH DYNAMIC EQUALIZER

CONVENTIONAL

Fig. 4

# EUROPEAN SEARCH REPORT

Application number

EP 80 85 0095

| | DOCUMENTS CONSIDERED TO BE RELEVANT | | CLASSIFICATION OF THE APPLICATION (Int. Cl. ³) |
|---|---|---|---|
| Category | Citation of document with indication, where appropriate, of relevant passages | Relevant to claim | |
| | US - A - 3 621 151 (J.B. WOOD)<br>* Figure; column 1, line 2 - column 3, line 70 * | 1,2 | H 03 G 5/18<br>G 11 B 5/45 |
| | -- | | |
| | US - A - 3 111 635 (E.P. SKOV et al.)<br>* Figures 2 and 3; column 1, line 39 - column 2, line 72; column 3, line 33 - column 6, line 29 * | 1 | |
| | -- | | |
| | AU - A - 62 435/65 (KRIESLER AUSTRALASIA)<br>* Figure 1; claims 1,3 and 4 * | 1,2 | |
| | ---- | | |

TECHNICAL FIELDS SEARCHED (Int.Cl. ³)

H 03 G 5
G 11 B 5
H 04 R 3

CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

| | | | |
|---|---|---|---|
| | The present search report has been drawn up for all claims | | |
| Place of search | Date of completion of the search | Examiner | |
| The Hague | 11-09-1980 | GYSEN | |

EPO Form 1503.1 06.78